# DEMANDE DE BREVET EUROPEEN

(11) **EP 2 960 957 A1**
(43) Date de publication de la demande: **30.12.2015**
(21) Numéro de dépôt: 15173849.9
(22) Date de dépôt: 25.06.2015
(51) Int. Cl.: H01L 51/00, H01L 51/42

(54) **DISPOSITIF PHOTOVOLTAIQUE ET SON PROCEDE DE FABRICATION**

(30) Priorité: 25.06.2014 FR 1455905; 23.10.2014 FR 1460204
(71) Demandeur: Dracula Technologies, 26000 Valence (FR)
(72) Inventeur: BARRET, Mickaël, 26260 MARSAZ (FR); BRUNET, Adrien, 38360 SASSENAGE (FR); CRUCHON, Brice, 26000 VALENCE (FR)
(74) Mandataire: Novagraaf Technologies

(57) **Abrégé**

La présente invention concerne un procédé de réalisation de dispositifs photovoltaïques comportant une ou plusieurs couches déposées par impression à jet d'encre.

## Description

La présente invention concerne de manière générale un procédé de réalisation de dispositifs photovoltaïques comportant une ou plusieurs couches déposées par impression à jet d'encre.

L'invention appartient au domaine de la réalisation de dispositifs photovoltaïques et, plus particulièrement aux dispositifs photovoltaïques sous forme d'empilements de matériaux de différentes natures.

Ces dispositifs sont élaborés à partir d'un ou plusieurs matériaux dit(s) fonctionnel(s) puisque réagissant sous l'effet d'un facteur externe. On parle de matériau présentant une fonction photovoltaïque lorsque, sous exposition lumineuse, il absorbe des photons et génère des charges. Dans un dispositif photovoltaïque, ces charges sont à l'origine du photocourant généré.

Concernant la réalisation de ces dispositifs, plusieurs technologies sont actuellement disponibles. Il s'agit plus particulièrement de technologies à base de silicium amorphe en couche mince (A-Si), d'alliages CIGS (cuivre, indium, gallium et sélénium) qui sont des dispositifs possédant leurs caractéristiques propres (électriques : performance, rendement de conversion ; et mécaniques : souplesse, rayon de courbure, aspect).

A cela, vient s'ajouter aujourd'hui la technologie photovoltaïque organique, généralement désigné par l'acronyme OPV (correspondant aux termes anglais « *Organic PhotoVoltaics* »), mettant en oeuvre, pour la couche active, des matériaux fonctionnels organiques, donneurs et accepteurs d'électrons, comme par exemple le P₃HT:PCBM (P₃HT étant l'acronyme désignant le poly(3-hexylthiophène) et le PCBM étant l'acronyme désignant [6,6]-phényl-C61-butanoate de méthyle), disposés entre deux électrodes conductrices avec potentiellement des couches interfaciales. Le tout est déposé successivement sur un substrat, rigide ou flexible.

Les applications actuelles sont cependant limitées par :
- la formation de différentes couches nécessairement de forme géométrique simple, par exemple rectangulaire (aplats),
- l'impossibilité technique de personnaliser les produits sans modification de l'outillage de réalisation,
- l'impossibilité technique de réaliser un dépôt par contact en raison de la sensibilité de certains matériaux et objets,
- des coûts élevés dus à un faible taux d'utilisation des matériaux mis en oeuvre (pertes importantes) en raison du type de procédé utilisé (sérigraphie ou autres techniques d'impression ou d'enduction ou de dépôt sous vide),
- des épaisseurs uniformes et déterminées de par le procédé de réalisation.

Afin de résoudre les inconvénients de l'art antérieur, le demandeur a mis au point un procédé de fabrication d'un dispositif photovoltaïque, dans lequel une ou plusieurs couches sont appliquées par impression à jet d'encre ce qui rend possible la personnalisation, à façon, des couches ainsi appliquées.

En outre, le procédé de fabrication selon l'invention permet d'obtenir des dispositifs possédant des formes plus ou moins complexes et personnalisables.

Plus particulièrement, la présente invention a pour objet un procédé de fabrication d'un dispositif photovoltaïque souple comprenant les étapes suivantes :
a) la fourniture d'un support conducteur, pouvant être .
   - soit un substrat non conducteur présentant au moins deux faces opposées, dont l'une est revêtue d'au moins une couche d'un premier matériau conducteur,
   - soit un substrat de premier matériau conducteur ;
b) le dépôt sur la couche ou le substrat de premier matériau conducteur, selon un motif prédéfini, d'au moins une première couche interfaciale composée :
   - soit d'un matériau organique semi-conducteur, dopé n ou p,
   - soit d'un matériau inorganique semi-conducteur, dopé n ou p,
   - soit d'un mélange hybride de matériaux semi-conducteurs, tous les deux dopés soit n, soit p, l'un des matériaux semi-conducteurs étant organique et l'autre matériau semi-conducteur étant inorganique ;
c) le dépôt sur la première couche interfaciale, selon un motif prédéfini, d'au moins une couche active photovoltaïque comprenant au moins un matériau semi-conducteur organique type p et un matériau semi-conducteur organique type n ;
d) le dépôt sur la couche active photovoltaïque, selon un motif prédéfini, d'au moins une deuxième couche interfaciale composée :
   - soit d'un matériau organique semi-conducteur, dopé n si la première couche interfaciale est composée d'un ou plusieurs matériaux semi-conducteurs dopés p ; ou inversement,
   - soit d'un matériau inorganique semi-conducteur, dopé n, si la première couche interfaciale est composée d'un ou plusieurs matériaux semi-conducteurs dopés p ; ou inversement,
   - soit d'un mélange de matériaux semi-conducteurs dopés n, comprenant au moins un matériau semi-conducteur organique et un matériau semi-conducteur inorganique, si la première couche interfaciale est composée d'un ou plusieurs matériaux semi-conducteurs dopés p ; ou inversement ;
e) le dépôt, selon un motif prédéfini, d'au moins une couche d'un deuxième matériau conducteur ;
f) le dépôt d'une reprise de contact au-dessus de la couche de deuxième matériau conducteur ;
   ledit procédé étant caractérisé en ce que le dépôt de la couche de premier matériau conducteur, et/ou le dépôt des deux couches interfaciales, et/ou le dépôt de la couche active photovoltaïque et/ou le dépôt de la couche de deuxième matériau conducteur et/ou le dépôt de la reprise de contact sont réalisés par un procédé d'impression numérique à jet d'encre suivant un motif prédéfini pouvant être réalisé à façon.

L'impression à jet d'encre permet de maitriser et d'adapter les caractéristiques optiques et électriques du dispositif photovoltaïque par la ou les variations de l'une au moins des caractéristiques suivantes :
- la nature des couches interfaciales,
- la nature de la couche active,
- la nature d'un ou des matériaux conducteur,
- le contrôle de l'épaisseur de la couche active,
- le contrôle de l'épaisseur des couches interfaciales, et
- le contrôle de l'épaisseur de la ou des couches de matériaux conducteurs.

En outre, l'utilisation de l'impression à jet d'encre permet de réduire considérablement et au juste nécessaire le volume de matériaux utilisés pour la réalisation des couches dont le coût impacte de façon considérable le prix de revient du produit final.

Le dispositif photovoltaïque doit être souple. Par souple, on entend au sens de la présente invention, un dispositif pouvant en outre supporter une modification réversible de sa forme sous contrainte mécanique et ainsi se conformer en acceptant un rayon de courbure supérieur à 1 cm.

L'obtention de dispositifs souples est rendue possible par l'utilisation de matériaux, formulations et substrats ayant été développés et sélectionnés pour leurs propriétés physico-chimiques. Les matériaux, formulations et substrats utilisés sont, pris indépendamment les uns des autres, intrinsèquement compatibles avec un dispositif souple.

Par exemple, pour les encres conductrices, les formulations développées sur la base du PEDOT/PSS visent à préserver la caractéristique élastique intrinsèque de la couche conductrice réalisée, en choisissant les solvants de dilution des encres.

La morphologie, l'organisation interne et la structure même de chacune des couches sont définies en intégrant leur conformabilité ou leur déformation réversible sous une contrainte mécanique de ces couches. Ainsi par exemple la stratégie d'impression utilisée vise à entrecroiser les dépôts successifs d'encre pour favoriser une organisation omnidirectionnelle propice à conserver les caractéristiques du matériau dans le cas d'une déformation mécanique *a postériori.* Ces stratégies d'impression sont la combinaison d'un nombre de passage d'impression pour un motif et une surface donnée, d'une résolution carrée de 300 DPI à 5040 DPI spécifique à chaque passage, de caractéristiques de gouttes propres à chaque passage et d'un séquencement précis (vitesse de chaque passage et temps entre 2 passages).

Au sens de la présente invention, on entend par résolution carrée de 300 DPI, une résolution comprenant 300 colonnes et 300 lignes de pixels, le tout disposé sur une surface d'un pouce carré.

Il est à noter également que l'empilement de ces couches est lui aussi développé et réalisé suivant un séquencement précis pour favoriser un comportement compatible à la déformation mécanique de l'ensemble, en ciblant notamment les interactions aux interfaces, mais aussi en préservant la structure de la ou des couches déjà imprimées et/ou du substrat. Ce séquencement comprend : les travaux préparatoires de la surface à imprimer (substrat ou couche), l'impression à proprement dite de la couche (tel que décrit plus haut) et les travaux de post-traitement. Les travaux préparatoires visent ainsi à amplifier les interactions liées aux énergies de surfaces, pour augmenter la résistance au décollement des deux couches ou de la couche et du substrat, sans altérer les caractéristiques morphologiques des états de surface, principalement la rugosité, et préserver ainsi les zones de photo-générescence définies par la topologie de l'empilement obtenu.

Disposer d'un dispositif souple selon l'invention est impératif pour son intégration dans des objets constitués de films souples techniques (film mince plastique), de textiles (tricotés, tissés ou non-tissés) de fibres plastique ou naturelles, ou de cuir ou tout autres matériaux flexibles.

Par exemple, un tel dispositif peut être appliqué sur la toile d'un parasol qui reste pliable et transportable comme à l'origine, tout en préservant les usages du produit. Un tel dispositif peut également intégrer les parties visibles d'un sac à dos, tout en préservant le confort d'utilisation du produit original ainsi que ses caractéristiques techniques. Un tel dispositif peut aussi être intégré dans la capote d'une poussette qui reste pliable et ajustable tel que le produit est à l'origine.

Un dispositif souple photovoltaïque selon l'invention permet de proposer un dispositif enroulable. Par exemple, un tel dispositif peut s'enrouler autour d'un tube à l'intérieur duquel peut se trouver une batterie qui est connectée au dispositif photovoltaïque. Une telle configuration offre l'avantage de proposer une surface active du dispositif supérieure à la surface du seul tube et donc de donner la possibilité de déployer le dispositif dans les conditions d'utilisation et de le replier pour limiter l'encombrement lorsqu'il n'est pas utilisé.

Il est à noter qu'un dispositif selon l'invention peut aussi être appliqué sur une surface rigide tridimensionnelle en l'adhésivant, en le collant, ou en le soudant. Il est à noter qu'un tel dispositif peut aussi être combiné à une coque rigide de smartphone. Toutes les fonctions originelles de la coque sont alors préservées tout en apportant la fonction unique du dispositif photovoltaïque souple.

Le support conducteur selon l'invention peut être soit un substrat entièrement constitué d'un matériau conducteur (dit premier matériau conducteur), soit un substrat non conducteur dont l'une au moins de ses faces est revêtue d'une couche de (premier) matériau conducteur, c'est-à-dire une couche conductrice appliquée ou non par impression à jet d'encre.

Selon un mode de réalisation avantageux de l'invention, l'empilement constitué du substrat non conducteur et de la première couche conductrice se présente sous la forme d'élément stratifié associant au moins un substrat non conducteur et un matériau conducteur.

L'utilisation d'un élément stratifié permet la réduction du nombre d'étapes du procédé selon l'invention.

Avantageusement, cet élément stratifié peut être un polyester aluminé.

Pour un tel mode de réalisation, on peut utiliser, à titre de substrat non conducteur, soit un substrat de nature organique (carton, papier ou à base de polymère par exemple), soit un substrat à base de matériaux inorganiques (verre, métal ou céramique par exemple).

La couche conductrice du substrat pourra dans la présente invention soit être déposée par jet d'encre, soit être structurée avec un motif défini réalisé par exemple :
- par gravure chimique ou physique à travers un masque,
- par dépôt sélectif à travers un masque ou par un procédé de microstructuration par photolithographie de type « *lift-off »,*
- par ablation avec un laser ponctuel, ou
- par ablation laser à travers un masque.

Selon un mode de réalisation particulièrement avantageux de la présentation, on applique, suivant un motif prédéfini, sur l'une des faces opposées du substrat non conducteur, une encre conductrice pour former une couche d'un premier matériau conducteur possédant une viscosité comprise entre 1 et 60 mPa/s à la température de travail (c'est-à-dire à la température de fonctionnement du dispositif d'impression jet d'encre) ; et une tension superficielle comprise entre 18 à 46 mN/m, puis on procède à un traitement thermique à une température comprise entre 50°C et 300°C.

Avantageusement, la ou les encres conductrices peuvent comprendre au moins :
- soit un ou plusieurs matériaux organiques conducteurs,
- soit un ou plusieurs matériaux inorganiques conducteurs, comme des nanoparticules métalliques d'aluminium, de cuivre, d'étain, ou d'argent, ou des nanoparticules d'oxydes conducteurs transparentes ou non, de carbone ou de graphite.
- soit un matériau hybride conducteur conjuguant des matériaux organiques et inorganiques, comme le mélange entre le poly(3,4-éthylènedioxythiophène) (PEDOT) et le poly(styrènesulfonate) de sodium (PSS) désigné par l'acronyme PEDOT/PSS.

Les tailles des nanoparticules métalliques peuvent avantageusement être comprises entre 1 nm et 50 µm.

Les propriétés liées aux tailles des nanoparticules métalliques de l'encre (du premier matériau conducteur) et à leur viscosité sont importantes, car des nanoparticules dont la taille est comprise entre 1 nm et 50 µm peuvent être projetables par une tête d'impression jet d'encre.

Le motif peut être réalisé par la structuration de la couche de premier matériau conducteur, quelque soit le mode de dépôt de cette couche (jet d'encre, gravure, ablation laser ou dépôt avec un masque). Le dépôt par jet d'encre permet de s'abstenir d'utiliser des outils onéreux de type masque ou laser.

On dépose sur la couche de premier matériau conducteur, selon l'invention et selon un motif prédéfini, une ou plusieurs couches :
- soit d'un matériau organique semiconducteur dopé n ou p,
- soit d'un matériau inorganique semiconducteur dopé n ou p,
- soit d'un mélange hybride de matériaux semi-conducteurs tous les deux dopés n ou p, l'un des matériaux semiconducteurs étant organique et l'autre matériau semiconducteur étant inorganique.

Cette couche est appelée première couche interfaciale.

Sur cette couche interfaciale, on dépose, selon le procédé de l'invention au moins une couche active photovoltaïque selon un motif prédéfini, ladite couche active comprenant au moins un matériau semi-conducteur organique dopé p et un matériau semi-conducteur dopé n.

Avantageusement, la couche active peut être constitué d'un polymère conjugué comme le poly(3-hexylthiophène) (P3HT), le PCBTDPP (polymère à base de carbazole et de diketopyrrolopyrrole) ou le PTB7 (poly(thienol[3,4-b]-thiophène/benzodithiophène), ou un oligomère dopé de type n et/ou p, ou un oxyde métallique comme les oxydes de zinc, ou un fullerène comme le PC60BM ([6,6]-phenyl-C₆₁-butanoate de méthyle), ou le PC70BM ([6,6]-phenyl-C₇₁-butanoate de méthyle), ou hybrides comme les pérovskytes.

Puis, selon l'invention, on dépose sur cette couche active photovoltaïque, selon un motif prédéfini, au moins une deuxième couche interfaciale composée :
- soit d'un matériau organique semi-conducteur, dopé n si la première couche interfaciale est composée d'un ou plusieurs matériaux semiconducteurs dopés p ; ou inversement,
- soit d'un matériau inorganique semiconducteur, dopé n, si la première couche interfaciale est composée d'un ou plusieurs matériaux semiconducteurs dopés p ; ou inversement,
- soit d'un mélange de matériaux semiconducteurs dopés n, comprenant au moins un matériau semiconducteur organique et un matériau semiconducteur inorganique, si la première couche interfaciale est composée d'un ou plusieurs matériaux semiconducteurs dopés p ; ou inversement.

Avantageusement, une au moins des couches interfaciales peut être constituée d'un matériau hybride, dopé de type n ou p, conjuguant des matériaux organiques et inorganiques choisi parmi les oxydes transparents conducteurs tels que les trioxydes de tungstène (WO₃), les dioxydes de titane (TiO₂), les oxydes de zinc (ZnO), ou le ZnO/Al, ou parmi les polymères conducteurs tels que le PEDOT/PSS qui est un mélange de deux polymères, le poly(3,4-éthylènedioxythiophène) (PEDOT) et le poly(styrène sulfonate) de sodium (PSS).

Après le dépôt de la deuxième couche interfaciale, on dépose selon un motif prédéfini, conformément au procédé selon l'invention, au moins une couche d'un deuxième matériau conducteur.

La couche de deuxième matériau conducteur peut être avantageusement transparente pour que la couche active photovoltaïque soit exposée à la lumière extérieure.

Avantageusement, la couche de deuxième matériau conducteur pourra également être appliquée par impression à jet d'encre de manière à optimiser la quantité de matière appliquée.

De manière préférée, les couches de premier matériau conducteur et de deuxième matériau conducteur peuvent être toutes deux transparentes, ce qui permet de créer un dispositif photovoltaïque transparent biface (c'est-à-dire un dispositif pouvant être exposé au soleil selon ses deux faces).

La couche de deuxième matériau conducteur peut comprendre au moins un mélange de deux polymères, le poly(3,4-éthylènedioxythiophène) (PEDOT) et le poly(styrène sulfonate) de sodium (PSS), ci-après désigné par l'acronyme PEDOT/PSS, ce mélange se présentant sous forme de solution colloïdale.

Après application de cette couche de deuxième matériau conducteur, on dépose sur cette dernière des particules métalliques matérialisant la reprise de contact. Cette reprise de contact peut être déposée suivant une forme prédéfinie. Par exemple, elle peut prendre la forme d'une grille.

Ces particules métalliques peuvent être en argent et permet d'améliorer la conductivité de la couche de deuxième matériau conducteur.

La reprise de contact permet d'extraire le photocourant engendré par l'absorption de photons.

Avantageusement, la reprise de contact peut être également appliquée par impression à jet d'encre.

Le dépôt de chacune des couches appliquées peut nécessiter un traitement thermique, en respect des contraintes des couches antérieures et du support (50 à 300°C), ou un traitement UV, par insolation, ou un traitement photonique, par exemple via une source pulsée au Xenon ou infrarouge, ou un traitement micro-ondes afin d'obtenir ses propriétés fonctionnelles.

La présente invention a encore pour objet un dispositif photovoltaïque susceptible d'être obtenu selon le procédé de l'invention.

Le dispositif photovoltaïque selon l'invention comprend un substrat pouvant prendre la forme d'un objet plan bidimensionnel (ou 2D) ou pouvant prendre la forme d'un objet tridimensionnel (ou 3D).

Par élément plan bidimensionnel, on entend au sens de la présente invention, un élément bidimensionnel, c'est-à-dire un élément dont la longueur et la largeur sont bien plus importantes que l'épaisseur. Par exemple, un élément plan bidimensionnel peut être un film, une feuille, ou une plaque.

Par objet tridimensionnel, on entend au sens de la présente invention, un objet en volume qui n'est pas un plan bidimensionnel.

Le dispositif photovoltaïque selon l'invention est apte à être appliqué à des produits de type équipement sportif léger, poussette, packaging, notamment de luxe (emballage, flaconnage, bouchon), bagagerie, maroquinerie, décoration intérieur, électronique, panneau publicitaire sur lieu de vente, équipement de protection individuel, ganterie, jouet et loisir éducatif, mobilier, parasol, textile, cycle, et automobile.

Le dispositif photovoltaïque selon l'invention peut être associé à un dispositif électroluminescent, l'association étant gérée par une carte électronique assurant les fonctions de conversion électrique et de stockage d'énergie au sein d'une batterie.

Avantageusement, la carte électronique peut intégrer un système d'optimisation du point de fonctionnement du dispositif photovoltaïque suivant ses propres caractéristiques optiques et électriques.

Par point de fonctionnement, on entend au sens de la présente invention, le couple comprenant une valeur de tension U et une valeur d'intensité I pour lequel la puissance induite par le dispositif photovoltaïque est maximale. Lorsque ce point de fonctionnement est atteint, on se trouve dans la configuration où I = Impp et U = Umpp, avec Impp désignant l'intensité en Ampère atteinte au point de fonctionnement et Umpp la tension en Volt atteinte au point de fonctionnement.

Un premier système d'optimisation du point de fonctionnement, utilisable dans le cadre de la présente invention, est le système connu sous la dénomination *« Max Power Point tracking* » en anglais (désigné par l'acronyme MPPT), qui consiste à balayer une plage de tensions par incrémentation pour repérer le couple (U, I) pour lequel la puissance induite par le dispositif photovoltaïque est maximale. Lorsque ce point est repéré, le système MPPT permet de converger vers ce point particulier.

Un second système d'optimisation du point de fonctionnement, utilisable dans le cadre de la présente invention, est le système connu sous la dénomination pseudo-MPPT. Ce système consiste à sélectionner une plage de tension dans laquelle se situe le point de fonctionnement. Ce système permet d'osciller autour du point de fonctionnement.

D'autres avantages et particularités de la présente invention résulteront de la description qui va suivre, donnée à titre d'exemple non limitatif et faite en référence aux figures annexées et aux exemples correspondants :
- la figure 1 représente une vue schématique d'un dispositif photovoltaïque dans lequel le substrat non conducteur est un objet tridimensionnel en verre transparent,
- la figure 2 représente une vue schématique d'un dispositif photovoltaïque dans lequel le support conducteur est constitué d'un film polyester aluminé,
- la figure 3 représente une vue schématique transversale d'un dispositif photovoltaïque dans lequel le substrat non conducteur est un garde boue pour le cycle,
- la figure 4 représente une vue schématique de profil d'un dispositif photovoltaïque associé à un dispositif électroluminescent dans lequel le substrat non conducteur est un garde-boue pour le cycle.

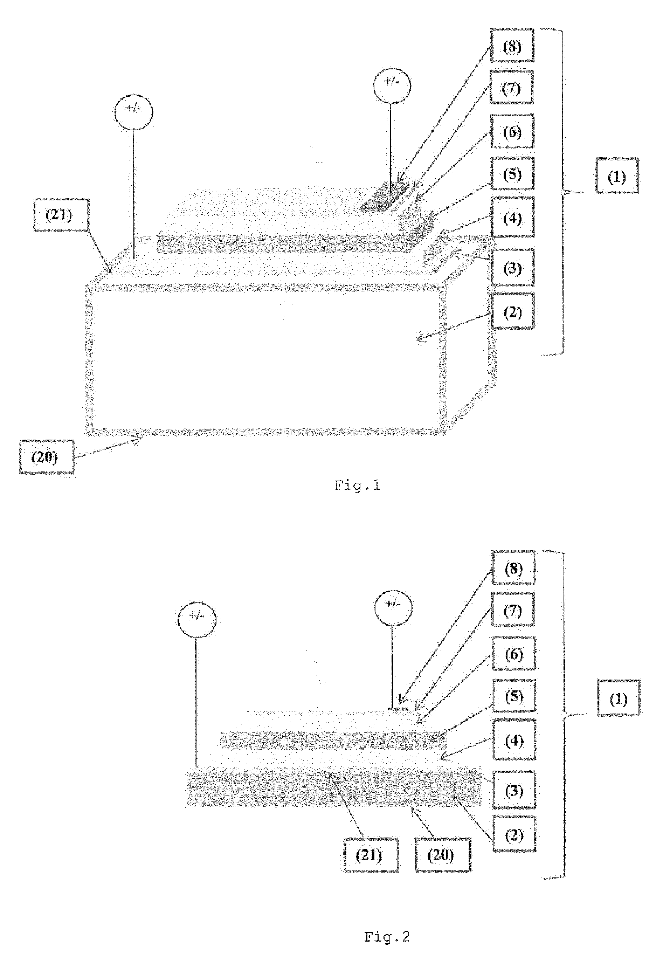

### EXEMPLE 1 (selon l'invention) illustré sur la figure 1 :

Substrat constitué d'un objet tridimensionnel en verre fin et souple.

On élabore un empilement de couches de natures différentes suivant le mode de réalisation du procédé de l'invention décrit ci-dessous sur un objet souple 3D en verre transparent. Avantageusement, cet objet 3D est un flacon en verre.

Cet empilement est fabriqué de la manière suivante :
a) la fourniture d'un objet souple en verre 3D transparent non-conducteur 2 ;
b) le dépôt par impression à jet d'encre selon un motif prédéfini d'un premier matériau conducteur 3 transparent, ou semi-transparent pouvant être de l'ITO ;
c) le dépôt par impression à jet d'encre sur le premier matériau conducteur 3, selon un motif prédéfini, d'une couche interfaciale 4 composée d'un matériau dopé n pouvant être un matériau inorganique, par exemple de l'oxyde de titane ;
d) le dépôt sur la première couche interfaciale 4, selon un motif prédéfini, d'une couche active photovoltaïque 5 comprenant au moins un matériau semiconducteur organique dopé p et un matériau semiconducteur organique dopé n, pouvant être un mélange P3HT :PCBM ;
e) le dépôt sur la couche active photovoltaïque 5, selon un motif prédéfini, d'une deuxième couche interfaciale 6 composée d'un matériau dopé p pouvant être un matériau organique, par exemple du PEDOT:PSS ;
f) le dépôt par impression à jet d'encre, selon un motif prédéfini, d'un deuxième matériau conducteur 7. Avantageusement, ce matériau sera transparent ou semi-transparent afin d'obtenir un dispositif photovoltaïque transparent ou semi-transparent sur le support verre transparent ; avantageusement, ce second matériau conducteur 7 peut être de l'argent imprimé par jet d'encre sous la forme d'un motif grille pour combiner la semi-transparence de ce motif et la conductivité élevée d'un dépôt réalisé à partir d'une encre conductrice à base de nanoparticules d'argent ; puis g) le dépôt d'une reprise de contact 8 par impression à jet d'encre.

### EXEMPLE 2 (selon l'invention) illustré sur la figure 2 :

Utilisation d'un substrat souple métallisé.

On élabore un empilement de couches de natures différentes suivant le mode de réalisation du procédé de l'invention décrit ci-dessous. Avantageusement, le procédé est réalisé sur un substrat souple 2D métallisé pouvant être un film polyester aluminé (PET/Al par exemple).

Cet empilement est fabriqué de la manière suivante :
a) la fourniture d'un substrat souple métallisé avec un motif prédéfini pouvant être réalisé par ablation laser ;
b) le dépôt par impression à jet d'encre sur le premier matériau conducteur 3, selon un motif prédéfini, d'une couche interfaciale 4 composée d'un matériau dopé n pouvant être un matériau inorganique, par exemple de l'oxyde de titane ;
c) le dépôt sur la première couche interfaciale 4, selon un motif prédéfini, d'une couche active photovoltaïque 5 comprenant au moins un matériau semiconducteur organique dopé p et un matériau semiconducteur organique dopé n, pouvant être un mélange P3HT :PCBM ;
d) le dépôt sur la couche active photovoltaïque 5, selon un motif prédéfini, d'une deuxième couche interfaciale 6 composée d'un matériau dopé p pouvant être un matériau organique, par exemple du PEDOT:PSS ;
e) le dépôt par impression à jet d'encre, selon un motif prédéfini, d'un deuxième matériau conducteur 7 transparent ou semi-transparent ; avantageusement, ce second matériau conducteur 7 peut être de l'argent imprimé par jet d'encre sous la forme d'un motif grille pour combiner la semi-transparence de ce motif et la conductivité élevée d'un dépôt réalisé à partir d'une encre conductrice à base de nanoparticules d'argent ; puis
f) le dépôt d'une reprise de contact 8 par impression à jet d'encre.

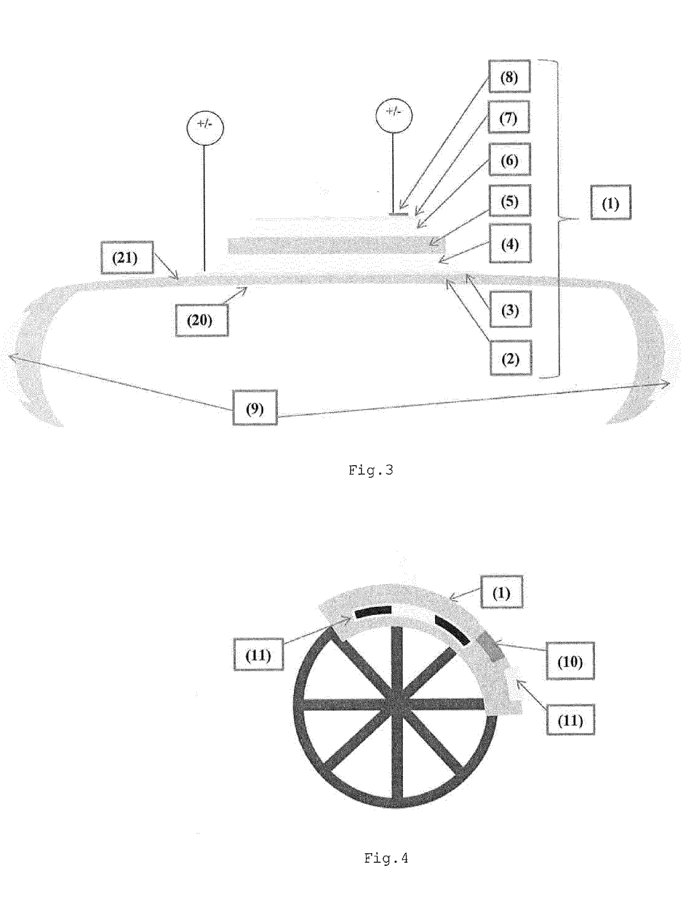

### EXEMPLE 3 (selon l'invention) illustré sur les figures 3 et 4

Substrat souple constitué d'un objet tridimensionnel en plastique souple.

On élabore un empilement de couches de natures différentes suivant le mode de réalisation du procédé de l'invention décrit ci-dessous sur un objet souple 3D en plastique. Avantageusement, cet objet 3D est un garde-boue pour le cycle.

Cet empilement est fabriqué de la manière suivante :
a) la fourniture d'un objet souple 3D plastique non-conducteur 2 ;
b) le dépôt par impression à jet d'encre selon un motif prédéfini d'un premier matériau conducteur 3 pouvant être de l'argent imprimé à partir d'une encre conductrice à base de nanoparticules d'argent ;
c) le dépôt par impression à jet d'encre sur le premier matériau conducteur 3, selon un motif prédéfini, d'une couche interfaciale 4 composée d'un matériau dopé n pouvant être un matériau inorganique, par exemple de l'oxyde de titane ;
d) le dépôt sur la première couche interfaciale 4, selon un motif prédéfini, d'une couche active photovoltaïque 5 comprenant au moins un matériau semiconducteur organique dopé p et un matériau semiconducteur organique dopé n, pouvant être un mélange P3HT:PCBM ;
e) le dépôt sur la couche active photovoltaïque 5, selon un motif prédéfini, d'une deuxième couche interfaciale 6 composée d'un matériau dopé p pouvant être un matériau organique, par exemple du PEDOT:PSS ;
f) le dépôt par impression à jet d'encre, selon un motif prédéfini, d'un deuxième matériau conducteur 7 transparent ou semi-transparent ; avantageusement, ce second matériau conducteur 7 peut être de l'argent imprimé par jet d'encre sous la forme d'un motif grille pour combiner la semi-transparence de ce motif et la conductivité élevée d'un dépôt réalisé à partir d'une encre conductrice à base de nanoparticules d'argent ; puis
g) le dépôt d'une reprise de contact 8 par impression à jet d'encre.

### EXEMPLE 4 (selon l'invention)

Association d'un dispositif photovoltaïque souple avec un dispositif électroluminescent.

On élabore un dispositif couplant un dispositif photovoltaïque 1 selon l'invention à un dispositif électroluminescent 9 (cf. figure 3). L'association des dispositifs électroluminescents 9 et photovoltaïque 1 est gérée par une carte électronique 10 (cf. figure 4) assurant les fonctions de conversion électrique et de stockage d'énergie au sein d'une batterie.

Avantageusement, la carte électronique 10 intègre un système d'optimisation du point de fonctionnement dudit dispositif (non représenté sur les figures 3 et 4).

Un tel dispositif peut être réalisé à partir des dispositifs photovoltaïques des exemples 1 à 3. En particulier, le système réalisé à partir d'un dispositif photovoltaïque de l'exemple 3 associé à un dispositif électroluminescent de décoration et/ou de sécurité 11 est appliqué sur un garde-boue de cycle (cf. figure 4).

### EXEMPLE 5 (selon l'invention):

Dispositif photovoltaïque sur support souple pour intégration dans un objet 3D

On élabore un empilement de couches de natures différentes suivant un des modes de réalisation du procédé de l'invention sur un support souple. Avantageusement, ce support souple est un polyester, par exemple un PET.

Le dispositif photovoltaïque 1 réalisé à partir de cet empilement est ensuite appliqué sur un objet 3D pour se conformer à celui-ci. Un tel dispositif peut être utilisé à partir des dispositifs photovoltaïques des exemples 1 à 3.

Avantageusement, on élabore un dispositif couplant ce dispositif photovoltaïque sur support souple à un dispositif électroluminescent 9.

## Revendications

1. Procédé de fabrication d'un dispositif photovoltaïque (1) souple, comprenant les étapes suivantes :
a) la fourniture d'un support conducteur, pouvant être :
- soit un substrat non conducteur (2) présentant au moins deux faces opposées (20, 21), dont l'une (21) est revêtue d'au moins une couche d'un premier matériau conducteur (3),
- soit un substrat de premier matériau conducteur (3) ;
b) le dépôt sur la couche ou le substrat de premier matériau conducteur (3), selon un motif prédéfini, d'au moins une première couche interfaciale (4) composée :
- soit d'un matériau organique semi-conducteur, dopé n ou p,
- soit d'un matériau inorganique semi-conducteur, dopé n ou p,
- soit d'un mélange hybride de matériaux semi-conducteurs, tous les deux dopés soit n, soit p, l'un des matériaux semi-conducteurs étant organique et l'autre matériau semi-conducteur étant inorganique ;
c) le dépôt sur la première couche interfaciale (4), selon un motif prédéfini, d'au moins une couche active photovoltaïque (5) comprenant au moins un matériau semi-conducteur organique dopé p et un matériau semi-conducteur organique dopé n ;
d) le dépôt sur la couche active photovoltaïque (5), selon un motif prédéfini, d'au moins une deuxième couche interfaciale (6) composée :
- soit d'un matériau organique semi-conducteur, dopé n si la première couche interfaciale est composée d'un ou plusieurs matériaux semi-conducteurs dopés p ; ou inversement,
- soit d'un matériau inorganique semi-conducteur, dopé n, si la première couche interfaciale est composée d'un ou plusieurs matériaux semi-conducteurs dopés p ; ou inversement,
- soit d'un mélange de matériaux semi-conducteurs dopés n, comprenant au moins un matériau semi-conducteur organique et un matériau semi-conducteur inorganique, si la première couche interfaciale est composée d'un ou plusieurs matériaux semi-conducteurs dopés p ; ou inversement ;
e) le dépôt, selon un motif prédéfini, d'au moins une couche d'un deuxième matériau conducteur (7) ;
f) le dépôt d'une reprise de contact (8) au-dessus de la couche de deuxième matériau conducteur (7) ;
ledit procédé étant **caractérisé en ce que** le dépôt de la couche de premier matériau conducteur (3), et/ou le dépôt des deux couches interfaciales (4) et (6), et/ou le dépôt de la couche active photovoltaïque (5) et/ou le dépôt de la couche de deuxième matériau conducteur (7) et/ou le dépôt de la reprise de contact (8) sont réalisés par un procédé d'impression numérique à jet d'encre suivant un motif prédéfini pouvant être réalisé à façon.

2. Procédé selon la revendication 1, dans lequel :
- on applique, suivant un motif prédéfini, sur l'une des faces opposées (20, 21) du substrat non conducteur (2), une encre conductrice pour former une couche d'un premier matériau conducteur (3) possédant une viscosité comprise entre 1 et 60amPa/s à la température de travail ; et une tension superficielle comprise entre 18 à 46 mN/m, puis
- on procède à un traitement thermique à une température comprise entre 50°C et 300°C.

3. Procédé selon l'une quelconque des revendications 1 ou 2, dans lequel la ou les encres conductrices comprennent au moins :
- soit un ou plusieurs matériaux organiques conducteurs,
- soit un ou plusieurs matériaux inorganiques conducteurs.
- soit un matériau hybride conducteur conjuguant des matériaux organiques et inorganiques.

4. Procédé selon l'une quelconque des revendications précédentes 1 à 3, dans lequel la couche ou le substrat de premier (3) et/ou la couche de deuxième (7) matériau conducteur sont transparentes.

5. Dispositif photovoltaïque (1) susceptible d'être obtenu selon le procédé tel que défini selon l'une quelconque des revendications 1 à 4.

6. Dispositif photovoltaïque (1) selon la revendication 5, dans lequel le substrat est un objet bidimensionnel ou tridimensionnel.

7. Dispositif photovoltaïque (1), selon l'une quelconque des revendications 5 ou 6, apte à être appliqué à des produits de type équipement sportif léger, poussette, packaging, bagagerie, maroquinerie, décoration intérieur, électronique, panneau publicitaire sur lieu de vente, équipement de protection individuel, ganterie, jouet et loisir éducatif, mobilier, parasol, textile, cycle, et automobile.

8. Dispositif photovoltaïque (1) selon l'une quelconque des revendications 5 à 7, **caractérisé en ce qu'**il est associé à un dispositif électroluminescent (9 ; 11), l'association étant gérée par une carte électronique (10) assurant les fonctions de conversion électrique et de stockage d'énergie au sein d'une batterie.

9. Dispositif photovoltaïque (1) selon la revendication 8, dans lequel la carte électronique (10) intègre un système d'optimisation du point de fonctionnement dudit dispositif (1).
